# EUROPÄISCHE PATENTANMELDUNG

(11) **EP 4 812 007 A2**
(43) Veröffentlichungstag der Anmeldung: **23.09.2026**
(21) Anmeldenummer: 26165308.3
(22) Anmeldetag: 17.03.2026
(51) Int. Cl.: H10W 44/20, H10W 20/20, H10D 62/00, H10W 44/00

(54) **HALBLEITERBAUELEMENT MIT INTEGRIERTER GALVANISCHER ISOLATION UND VERFAHREN ZUR HERSTELLUNG DIESES HALBLEITERBAUELEMENTS**

(30) Priorität: 20.03.2025 DE 102025110895
(71) Anmelder: Fraunhofer-Gesellschaft zur Förderung der angewandten Forschung e.V., 80686 München (DE)
(72) Erfinder: Basler, Michael, 79108 Freiburg (DE)
(74) Vertreter: LBP Lemcke, Brommer & Partner Patentanwälte mbB

(57) **Zusammenfassung**

Die Erfindung betrifft ein Halbleiterbauelement mit integrierter galvanischer Isolation und ein Verfahren zur Herstellung eines solchen Halbleiterbauelements mit Daten- und/oder Energieübertragung zwischen zwei galvanisch voneinander getrennten Schaltungsdomänen mit den folgenden Verfahrensschritten:
A Bereitstellen eines isolierenden Substrats mit einer Oberseite und einer Unterseite;
B Ausbilden einer Halbleiterschichtstruktur durch Aufwachsen und/oder Abscheiden von Epitaxieschichten auf der Oberseite des Substrats, wobei Schaltungen aus aktiven und/oder passiven Schaltungskomponenten zumindest einer der zwei Schaltungsdomänen ausgebildet werden;
C Aufbringen einer Vorderseitenmetallisierung in zumindest einer vorderseitigen Metallisierungsebene mittelbar oder unmittelbar auf der dem Substrat abgewandten Vorderseite der Halbleiterschichtstruktur, wobei die Vorderseitenmetallisierung ein vorderseitiges Übertragungselement für die galvanische Trennung umfasst;
D Aufbringen einer Rückseitenmetallisierung in zumindest einer rückseitigen Metallisierungsebene mittelbar oder unmittelbar auf der der Halbleiterschichtstruktur abgewandten Unterseite des Substrats, wobei die rückseitige Metallisierungsebene ein rückseitiges Übertragungselement für die galvanische Trennung umfasst;
E Ausbilden einer elektrisch leitenden Verbindung zwischen zumindest einer Schaltungsdomäne aus Verfahrensschritt B und dem vorderseitigen oder dem rückseitigen Übertragungselement.

## Beschreibung

Die Erfindung betrifft ein Verfahren zur Herstellung eines Halbleiterbauelements mit Daten und/oder Energieübertragung zwischen zwei galvanisch voneinander getrennten Schaltungsdomänen gemäß Anspruch 1 sowie ein Halbleiterbauelement mit Daten und/oder Energieübertragung zwischen zwei galvanisch voneinander getrennten Schaltungsdomänen gemäß Anspruch 8.

Bei Halbleiterbauelementen mit galvanischer Trennung (auch: galvanische Isolierung, galvanische Entkopplung oder Potentialtrennung) werden zwei elektrische Schaltkreise voneinander getrennt, sodass keine direkte elektrische Verbindung besteht, während Signale und/oder Energie weiterhin übertragen werden können. Solche Halbleiterbauelemente mit galvanischer Trennung (im Folgenden auch Isolationsbauelemente) werden in Anwendungen zur Erhöhung der Sicherheit, zur Reduzierung von Störungen und Erfüllung von Regulierungsstandards benötigt. Gründe sind in erster Linie der Personenschutz, aber auch der Schutz empfindlicher Bauteile, die Reduktion von Störungen und Masseschleifen oder auch der Funktionserhalt bei unterschiedlichen Potentialen. Immer mehr industrielle und medizinische Standards erfordern, dass Hochspannungs- und Niederspannungsschaltungen voneinander isoliert werden, um Benutzer und Gerät zu schützen.

Um trotz elektrischer Isolation Daten und/oder Energie zu übertragen, sind verschiedene Methoden bekannt:
Bei der Datenübertragung basieren traditionelle Isolationsbauelemente zum Beispiel auf optischer Übertragung, meist im Nahinfrarotbereich. Der Isolationsgrad eines solchen Optokopplers wird durch den Abstand und das dielektrische Material zwischen Lichtquelle und Fotodetektor bestimmt.

Alternativ sind Isolationsbauelemente zur Datenübertragung auf der Basis von Funkfrequenzen (RF) mit kapazitiver Kopplung oder induktiver Kopplung bekannt: RF-Isolatoren nutzen zum Beispiel drahtlose Übertragung zwischen zwei gestapelten oder nebeneinander platzierten Chips über silizium-integrierte Nahfeldantennen.

Kapazitive galvanische Isolatoren geeignet für Datenübertragung funktionieren auf der Basis von beispielsweise silizium-integrierten Kondensatoren. Während induktive Isolationstransformatoren sich für Daten- und/oder Energieübertragung eignen. Auch LC-Hybrid-Ansätze sind bekannt, bei denen eine doppelte Isolationsbarriere in Form eines Isolationskondensators und eines Isolationstransformators verwendet wird. Diese Ansätze eignen sich insbesondere für sehr hohe Isolationsspannungen und Energieübertragung.

Aus dem Stand der Technik sind einerseits Technologien bekannt, die auf einem beliebigen Trägersubstrat einen Halbleiterschichtaufbau mit aktiven und passiven Schaltungen zeigen. Die galvanische Trennung wird durch eine separate Isolationsschicht realisiert. Eine solche Architektur ist beispielsweise in dem Dokument US 9,935,098 B2beschrieben. Systeme nach dem Stand der Technik sind aufwendig in der Herstellung und kostenintensiv, jedoch hochintegrierbar. Ein weiterer Nachteil ist, dass beispielsweise Produkte wie beispielsweise digitale Isolatoren in diesen Technologien mit zwei Chips/Halbleiterbauelementen hergestellt werden müssen. Ursache hierfür sind leitfähige Substrate.

Alternativ ist es aus dem Stand der Technik bekannt, reine Isolationsbauelemente ohne weitere Halbleiterschichten für weitergehende Funktionalitäten mit einem isolierenden Substrat aufzubauen. Ansätze nach diesem Stand der Technik benötigen zusätzliche aktive Schaltungen in Halbleitertechnologien für die Realisierung einer galvanisch getrennten Daten- und/oder Energieübertragung. Nachteilig ist der dadurch erhöhte Platzbedarf.

Insbesondere im Bereich der Leistungselektronik finden galvanisch isolierte Gate-Treiber ihre Anwendung, um beispielsweise "floatende" Leistungstransistoren anzusteuern oder den Leistungsteil von der Ansteuerung zu trennen. Diese Leistungshalbleiter und -transistoren sind die Schlüsselkomponenten aller Leistungselektroniksysteme. Das Standard-Halbleitermaterial bildet Silizium (Si), dass vermehrt durch Materialien mit höherer Bandlücke, wie Galliumnitrid (GaN) oder Siliziumkarbird (SiC), ersetzt wird. Insbesondere laterale GaN-basierte-Leistungstransistoren (bekannt als High-Electron-Mobility-Transistors - HEMTs) werden zunehmend in Leistungselektroniksysteme eingesetzt, aufgrund der besser physikalischen Eigenschaften und Kennzahlen im Vergleich zu Si-basierte Transistoren. Ein weiterer Vorteil ist die laterale Struktur im Vergleich beispielsweise zu Si-MOSFETs, die die monolithische Integration zusätzlicher Peripherie der Leistungselektronik wie Gate-Treiber zum Leistungshalbleiter auf einem Chip ermöglicht. Ersten Produkte sind bereits verfügbar, die den Leistungstransistor und den Gate-Treiber monolithisch in einer GaN-Technologie integrieren. Isolierte GaN-Gate-Treiber existieren bisher jedoch nicht. Ein gängiger Lösungsansatz besteht darin, den GaN-Leistungstransistor mit einem monolithisch integrierten Gate-Treiber oder einem externen S-Gate-Treiber anzusteuern und das Signal über einen Digitalen Isolator basierend auf Si-CMOS oder BCD Technologie zu isolieren. Zusätzlich muss der die Versorgungsspannung des Gate-Treibers mittels isoliertem DC/DC Wandler galvanisch entkoppelt werden.

Vor diesem Hintergrund ist es Aufgabe der Erfindung, ein Halbleiterbauelement zur Daten- und/oder Energieübertragung zwischen zwei galvanisch voneinander getrennten Schaltungsdomänen vorzuschlagen, dass einfach in der Herstellung ist, die erforderlichen Isolationsklassen gewährleistet.

Gelöst wird diese Aufgabe durch ein Verfahren zur Herstellung eines Halbleiterbauelements gemäß Anspruch 1. Bevorzugte Ausgestaltungen des erfindungsgemäßen Herstellungsverfahrens finden sich in den Ansprüchen 2 bis 7. Weiter gelöst ist die Aufgabe durch ein erfindungsgemäßes Halbleiterbauelement gemäß Anspruch 8. Bevorzugte Ausgestaltungen dieses Halbleiterbauelements finden sich in den Ansprüchen 9 bis 16. Hiermit wird der Wortlaut sämtlicher Ansprüche explizit per Referenz in die Beschreibung einbezogen.

Das erfindungsgemäße Verfahren zur Herstellung eines Halbleiterbauelements mit Daten- und/oder Energieübertragung zwischen zwei galvanisch voneinander getrennten Schaltungsdomänen umfasst die folgenden Verfahrensschritte:
A Bereitstellen eines isolierenden Substrats mit einer Oberseite und einer Unterseite.
B Ausbilden einer Halbleiterschichtstruktur durch Aufwachsen und/oder Abscheiden von Epitaxieschichten auf der Oberseite des Substrats. Hierdurch werden Schaltungen aus aktiven und/oder passiven Schaltungskomponenten für zumindest eine der zwei galvanisch voneinander getrennten Schaltungsdomänen ausgebildet.
C Aufbringen einer Vorderseitenmetallisierung in zumindest einer vorderseitigen Metallisierungsebene mittelbar oder unmittelbar auf der dem Substrat abgewandten Vorderseite der Halbleiterschichtstruktur. Dabei umfasst die Vorderseitenmetallisierung ein vorderseitiges Übertragungselement für die galvanische Trennung.
D Aufbringen einer Rückseitenmetallisierung in zumindest einer rückseitigen Metallisierungsebene mittelbar oder unmittelbar auf der der Halbleiterschichtstruktur abgewandten Unterseite des Substrats. Dabei umfasst die rückseitige Metallisierungsebene ein rückseitiges Übertragungselement für die galvanische Trennung.
E Ausbilden einer elektrisch leitenden Verbindung zwischen zumindest einer Schaltungsdomänen aus Verfahrensschritt B und dem vorderseitigen oder rückseitigen Übertragungselement.

Die galvanische Trennung wird durch das isolierende Substrat realisiert. Die Daten- und/oder Energieübertragung erfolgt mittels des vorderseitigen und des rückseitigen Übertragungselements, die auf zwei verschiedenen Seiten des Substrats angeordnet sind.

Hierdurch ergibt sich zum einen der Vorteil, dass die galvanische Trennung über das Substrat realisiert wird. Es müssen keine dicken Isolationsschichten, wie aus dem Stand der Technik bekannt, aufgebracht werden. Dadurch reduzieren sich die Kosten. Zum anderen ergibt sich der Vorteil, dass sich das Isolationselement mit integrierten Schaltungen aus der ausgewählten Technologie realisieren lässt und keine zwei Technologien und Halbleitersysteme eingesetzt werden müssen. Insgesamt ist daher eine hohe Kompaktheit des Halbleiterbauelements möglich.

Die erfindungsgemäße Aufgabe ist ebenfalls gelöst durch ein Halbleiterbauelement mit den Merkmalen des Anspruchs 8.

Das Halbleiterbauelement weist Mittel zur Daten- und/oder Energieübertragung zwischen zwei galvanisch voneinander getrennten Schaltungsdomänen auf. Weiter umfasst das Halbleiterbauelement ein isolierendes Substrat und eine Halbleiterschichtstruktur, die Schaltungen aus aktiven und/oder passiven Schaltungskomponenten für zumindest eine erste Schaltungsdomäne der beiden galvanisch voneinander getrennten Schaltungsdomänen umfasst. Das isolierende Substrat weist eine Oberseite und eine Unterseite auf. Oberseite und Unterseite sind zufällig gewählt und bedeuten keine Beschränkung.

Die Halbleiterschichtstruktur ist auf einer Oberseite des Substrats angeordnet. Auf der Vorderseite der Halbleiterschichtstruktur wiederum ist eine vorderseitige Metallisierungsebene angeordnet. Die Vorderseite der Halbleiterschichtstruktur ist die dem Substrat abgewandte Seite der Halbleiterschichtstruktur. In der vorderseitigen Metallisierungsebene ist ein vorderseitiges Übertragungselement für die galvanische Trennung ausgebildet. An einer der Halbleiterschichtstruktur abgewandten Unterseite des Substrats ist mittelbar oder unmittelbar eine rückseitige Metallisierungsebene angeordnet. Die rückseitige Metallisierungsebene umfasst ein rückseitiges Übertragungselement für die galvanische Trennung.

Das vorderseitige und das rückseitige Übertragungselement sind zusammenwirkend angeordnet und ausgebildet, Daten- und /oder Energie kontaktlos durch magnetische Kopplung, elektrische Kopplung oder mittels elektromagnetischer Wellen zwischen dem vorderseitigen Übertragungselement und dem rückseitigen Übertragungselement zu übertragen. Die erste Schaltungsdomäne ist mit dem vorderseitigen Übertragungselement oder dem rückseitigen Übertragungselement elektrisch leitend verbunden.

Das erfindungsgemäße Halbleiterbauelement wird bevorzugt mittels des oben beschriebenen erfindungsgemäßen Verfahrens beziehungsweise einer bevorzugten Ausführungsform des erfindungsgemäßen Verfahrens hergestellt. Das erfindungsgemäße Verfahren ist bevorzugt zur Ausbildung eines erfindungsgemäßen Halbleiterbauelements beziehungsweise einer bevorzugten Ausführungsform ausgebildet. Das erfindungsgemäße Halbleiterbauelement zeigt ebenfalls die vorgenannten Vorteile des erfindungsgemäßen Verfahrens.

In einer bevorzugten Ausführungsform der Erfindung ist das Halbleiterbauelement als monolithisch integriertes Halbleiterbauelement ausgeführt. Hierdurch ergibt sich der Vorteil, dass sich das Isolationsbauelement mit integrierten Schaltungen aus der ausgewählten Technologie realisieren lässt und keine zwei Technologien und Halbleitersysteme eingesetzt werden müssen. Die erfindungsgemäße Lösung bietet daher die Möglichkeit die galvanische Trennung zum Gate-Treiber und/oder Leistungstransistor monolithisch integriert auszubilden. Insgesamt ist daher eine hohe Kompaktheit des Halbleiterbauelements möglich.

In einer weiteren Ausführungsform der Erfindung werden in Verfahrensschritt B in der Halbleiterschichtstruktur beide galvanisch voneinander getrennten Schaltungsdomänen ausgebildet. Es werden in der Halbleiterschichtstruktur eine erste und eine zweite Schaltungsdomäne ausgebildet. Hierdurch ergibt sich der Vorteil, dass das gesamte Halbleiterbauelement in einfacher und kostengünstiger Art und Weise in einer Halbleitertechnologie ausgebildet werden kann. Das Halbleiterbauelement umfasst somit zwei Bereiche, die beiden Schaltungsdomänen, in der Halbleiterschichtstrukur mit aktiven und/oder passiven Schaltungskomponenten, die bestimmte gewünschte Funktionalitäten aufweisen.

Bevorzugt werden in einem weiteren Verfahrensschritt elektrisch leitende Verbindungen zwischen den beiden Schaltungsdomänen und jeweils einem Übertragungselement für die Übertragung von Daten und/oder Energie ausgebildet. Alternativ kann eine elektrisch leitende Verbindung zwischen der ersten Schaltungsdomäne und dem vorderseitigen Übertragungselement und der zweiten Schaltungsdomäne und dem rückseitigen Übertragungselement ausgebildet werden oder eine elektrisch leitende Verbindung zwischen der ersten Schaltungsdomäne und dem rückseitigen Übertragungselement und der zweiten Schaltungsdomäne und dem vorderseitigen Übertragungselement. Je nach Variante werden entsprechende Durchkontaktierungen ausgebildet.

Die Übertragung von Daten und/oder Energie zwischen dem vorderseitigen und dem rückseitigen Übertragungselement erfolgt induktiv, kapazitiv und/oder mittels einer RF-Antennenordnung durch elektromagnetische Wellen. Alle drei Ansätze haben unterschiedliche Vor- und Nachteile, die aus dem Stand der Technik hinlänglich bekannt sind.

Bevorzugt umfasst das erfindungsgemäße Halbleiterbauelement Mittel zur induktiven und/oder kapazitiven Übertragung von Daten und/oder Energie oder eine RF-Antennenanordnung zur Übertragung von Daten und/oder Energie durch elektromagnetische Wellen:
Für die induktive Übertragung von Daten und/oder Energie sind das vorderseitige und das rückseitige Übertragungselement bevorzugt als Spulenpaar ausgebildet: Es sind daher zumindest zwei Spulen vorgesehen, die auf verschiedenen Seiten der Isolationsbarriere für die galvanische Trennung angeordnet sind. Bevorzugt wird die induktive Kopplung mittels eines Mikrotransformators realisiert. Der Transformator umfasst eine Primärwicklung und eine Sekundärwicklung, die auf gegenüberliegenden Seiten der Isolationsbarriere angeordnet sind. Grundsätzlich kann die Daten- und/oder Energieübertragung wie aus dem Stand der Technik bekannt ausgebildet sein. Bevorzugt sind das vorderseitige und das rückseitige Übertragungselement als Spiralspulen ausgebildet. Insbesondere liegt die Anzahl der Windungen der Spulen zwischen 1 und 30, höchst vorzugsweise 3 bis 10 Windungen.

Die kapazitive Übertragung von Daten und/oder Energie zwischen dem vorderseitigen und dem rückseitigen Übertragungselement erfolgt bevorzugt mittels eines Kondensators. Dazu sind das vorderseitige und das rückseitige Übertragungselement für die Übertragung von Daten und/oder Energie als Kondensatorplatten ausgebildet. Die beiden Kondensatorplatten sind jeweils auf gegenüberliegenden Seiten der Isolationsbarriere angeordnet. Auch diese Ausführungsform kann grundsätzlich wie aus dem Stand der Technik bekannt ausgeführt werden.

Auch Kombinationen wie LC-Hybrid-Ansätze liegen im Rahmen der Erfindung. Insbesondere sehr hohe Isolationen werden durch LC-Hybrid-Ansätze, das heißt durch die Kombination von induktiver und kapazitiver Kopplung, erreicht. Diese Isolationsbauelemente werden durch eine doppelte Isolationsbarriere in Form eines Isolationskondensators und eines Isolationstransformators realisiert. Solche Systeme sind beispielsweise in den Veröffentlichungen N. Greco et al., "A 100-mW fully integrated DC-DC converter with double galvanic isolation," in ESSCIRC 2017 - 43rd IEEE European Solid State Circuits Conference, Leuven, Belgium, 2017, pp. 291-294. und N. Greco et al. "A Double-Isolated DC-DC Converter Based on Integrated ${LC}$ Resonant Barriers," IEEE Transactions on Circuits and Systems I: Regular Papers, vol. 65, no. 12, pp. 4423-4433, 2018, doi: 10.1109/TCSI.2018.2840450 beschrieben.

Alternativ sind das rückseitige und das vorderseitige Übertragungselement für die Übertragung von Daten und/oder Energie als RF-Antennenanordnung mit Sender und Empfänger ausgebildet. Bevorzugt ist das Halbleiterbauelement als RF- Antennenordnung für die drahtlose Übertragung von Daten und/oder Energie zwischen integrierten Nahfeldantennen ausgebildet.

In einer bevorzugten Ausführungsform der Erfindung wird das Halbleiterbauelement auf der Basis von III-V-Verbindungshalbleitern ausgebildet, insbesondere bevorzugt im AlGaN/GaN-Materialsystem. Hierdurch ergibt sich der Vorteil, dass mittels der AlGaN/GaN-Technologie verschiedene aktive Bauelemente, wie normally-on und normally-off High-Electron-Mobility Transistoren (HEMTs), Schottky-Barrier Dioden (SBDs), Lateral Field-Effect Rectifer (LFERs) sowie passive Komponente wie Widerstände, Kondensatoren und Induktivitäten zur Realisierung der integrierten Schaltungen ausgebildet werden können. Hierdurch kann in einfacher Art und Weise auf vorbekannte Prozesstechnologien zurückgegriffen werden.

Vorteilhafterweise wird durch die Erfindung der Einsatz lateraler GaN-Transistoren (HEMTs) in der Leistungselektronik verbessert. Mit dem erfindungsgemäßen Ansatz sind in der GaN-Technologie monolithisch integrierte Leistungstransistoren mit isolierten GaN-Gate-Treibern möglich.

Alternativ wird das Halbleiterbauelement auf der Basis von Silizium ausgebildet. Auch hier ergibt sich der Vorteil, dass auf grundlegende vorbekannte Technologien zurückgegriffen werden kann. Das Halbleiterbauelement lässt sich mit integrierten Schaltungen aus der jeweiligen Technologie beziehungsweise aus dem jeweiligen Materialsystem realisieren, sodass eine hohe Kompaktheit der galvanischen Isolation von Daten- und/oder Energieübertragung möglich ist.

In einer bevorzugten Ausführungsform der Erfindung ist das isolierende Substrat aus Saphir, aus semi-isolierendem Siliziumkarbid oder als Silizium-auf-Isolator-Substrat ausgebildet. Bevorzugt ist das Substrat als Silizium-auf-Saphir-Substrat ausgebildet. Auf diesen Substraten können mit vorbekannten Verfahren Epitaxieschichten aufwachsen werden. Durch die elektrisch isolierenden Eigenschaften der Substratmaterialien kann in einfacher und kostengünstiger Art und Weise die Isolierung für die galvanische Trennung erreicht werden, ohne das zusätzliche Schichten oder Strukturen vorgesehen werden müssen.

In einer bevorzugten Ausführungsform der Erfindung wird die Dicke des Substrats in Abhängigkeit von der gewünschten Isolationsspannung des Halbleiterbauelements derart gewählt, dass die galvanische Trennung bei Betrieb des Halbleiterbauelements gewährleistet ist. Die Isolationsspannung ist von der Dicke des Substrats zwischen den beiden Übertragungselementen abhängig, sodass anhand der Dicke des Substrats die gewünschte Isolationsklasse eingestellt werden kann. Dabei ist eine minimale Dicke des Wafer-Substrats gegeben, um das Substrat entsprechend prozessieren zu können. Mit steigender Dicke steigt die Isolationsspannung.

Hierdurch ergibt sich der Vorteil, dass in einfacher Art und Weise durch ein vorhandenes Element, nämlich das Substrat, die Isolationsspannung gewährleistet werden kann. Es müssen keine zusätzlichen Isolationsschichten aufgetragen werden, die üblicherweise die Kosten erhöhen.

Die notwendige Dicke ist abhängig vom verwendeten Substrat. Typische Beispiele sind:
48 V/µm für Saphir und 300-500 V/µm für semi-isolierendes SiC. Bei typischen Substratdicken von 200 µm für Saphir und 75 µm für semi-isolierendes SiC entspricht dies einer Isolationsspannung von ca. 10 kV und >20 kV.

Um die Kopplung zwischen dem vorderseitigen und dem rückseitigen Übertragungselement zu erhöhen, sind in einer bevorzugten Ausführungsform eine oder mehrere Ätzstufen vorgesehen. Diese können beispielsweise im Substrat vorgesehen sein. Die Ausbildung der Ätzstufe erfolgt bevorzugt in einem zusätzlichen Verfahrensschritt als Teil der Rückseitenbearbeitung. Durch die Ätzstufen erhöht sich folglich die Effizienz der Kopplung.

In einer bevorzugten Ausführungsform der Erfindung werden in einem zusätzlichen Verfahrensschritt vor dem Verfahrensschritt E zumindest in dem Substrat in einem Bereich zwischen dem vorderseitigen Übertragungselement und dem rückseitigen Übertragungselement mittels Ätzverfahren zumindest eine Ätzstufe ausgebildet. Dieser Verfahrensschritt erfolgt bevorzugt im Rahmen der Rückseitenprozessierung. Die Ätzstufen ist bevorzugt im Substrat des Halbleiterbauelements angeordnet. Durch die Ätzstufen wird die Kopplung zwischen den zwei Übertragungselementen erhöht. Dadurch erhöht sich die Effizienz der galvanischen Kopplung.

In einer bevorzugten Ausführungsform der Erfindung ist in der vorderseitigen Metallisierungsebene zumindest ein erster elektrischer Kontaktbereich aus metallischem Material zur Kontaktierung der ersten Schaltungsdomäne und/oder der zweiten Schaltungsdomäne ausgebildet. Vorzugsweise ist ein zweiter elektrischer Kontaktbereich aus metallischem Material zur Kontaktierung des rückseitigen Übertragungselements über Durchkontaktierungen (VIAs) ausgebildet. Mittels dieser Durchkontaktierungen kann somit auch die Rückseite über die Vorderseite des Halbleiterbauelements kontaktiert werden.

Bevorzugt sind die vorderseitige Metallisierungsebene und/oder die rückseitige Metallisierungsebene mehrschichtig ausgebildet. Zwischen den Metalllagen der vorderseitigen Metallisierungsebene sind bevorzugt Durchkontaktierungsebenen vorgesehen, die leitende Durchkontaktierungen umfassen. Insbesondere bevorzugt ist in der vorderseitigen Metallisierungsebene zumindest eine Durchkontaktierungsebene vorgesehen, die zumindest eine leitende Durchkontaktierung durch das Substrat zur rückseitigen Metallisierungsebene aufweist.

Um das Halbleiterbauelement mit anderen Schaltungsteilen oder der Außenwelt elektrisch verbinden zu können, ist bevorzugt zumindest ein Bond-Bereich vorgesehen, insbesondere bevorzugt mehrere Bonde-Bereiche, die über die elektrischen Metallisierungsebenen verschiedene Strukturen des Halbleiterbauelements kontaktieren.

Bevorzugt werden nur diese Bond-Bereiche, beziehungsweise bevorzugt nur ein Bond-Bereich, freigelegt zur Ankontaktierung. Alle anderen Strukturen sind bevorzugt durch eine Siliziumnitrid- oder Siliziumoxid-Schicht bedeckt und damit sowohl elektrisch isoliert als auch geschützt. Bevorzugt ist diese oberste dielektrische Schicht als Siliziumnitrid- oder Siliziumoxid-Schicht ausgebildet. Diese oberste dielektrische Schicht dient gleichzeitig für die Passivierung der Außenseite und Freistellung der Bond-Bereiche.

In einer bevorzugten Ausführungsform des erfindungsgemäßen Verfahrens werden zumindest die folgenden Schritte durchgeführt: Zunächst erfolgt die Frontseitenprozessierung. Dazu wird ein Substrat bereitgestellt, auf dem bevorzugt mittels Epitaxieverfahren Halbleiterschichten abgeschieden werden, die mehrere elektrische und elektronische Komponenten beziehungsweise Schaltungen enthalten. Die Funktionalität dieser Komponenten und Schaltungen ist abhängig von der späteren geplanten Anwendung des Halbleiterbauelements.

Die Separierung oder Isolierung der aktiven Strukturen erfolgt bevorzugt mittels Implantations- oder Ätzverfahren.

Zur Kontaktierung werden mehrere Metallisierungsebenen aufgebracht und Anschlüsse sowie leitende Durchkontaktierungen hergestellt. In den Metallisierungsebenen wird das vorderseitige Übertragungselement ausgebildet. Über die leitenden Durchkontaktierungen sind alle notwendigen Anschlüsse zur Außenseite des Bauelements hergestellt.

Im Anschluss erfolgt die Rückseitenprozessierung. Bei der Rückseitenprozessierung wird der Substratwafer auf die gewünschte Dicke abgedünnt. Um die Rückseite mit der Vorderseite über eine Metallisierungsebene zu kontaktieren, werden tiefe Gräben geätzt.

Die Kopplung des Isolationselements und damit auch die Isolationsklasse beziehungsweise die Isolationsspannung hängt von der Dicke des Substrats ab. Optional können eine oder mehrere Ätzstufen vorgesehen werden, um die Kopplung zu erhöhen.

In einem nächsten Schritt wird die Rückseitenmetallisierung ausgebildet, bei der zumindest eine Metallisierungsebene auf der Rückseite des Halbleiterbauelements ausgebildet wird. In dieser Metallisierungsebene wird das rückseitige Übertragungselement ausgebildet.

Optional können weitere Prozessierungsschritte wie Vereinzelung, Verbinden mit weiteren Elementen und/oder Verkapselung durchgeführt werden.

Das erfindungsgemäße Halbleiterbauelement kann sowohl mit als auch ohne Planarisierungsverfahren hergestellt werden. Falls keine Planarisierungsverfahren genutzt werden, entsteht eine Topographie.

Das erfindungsgemäße Halbleiterbauelement beziehungsweise eine bevorzugte Ausführungsform des erfindungsgemäßen Halbleiterbauelements sind grundsätzlich geeignet für den Einsatz in Produkten wie Digital-Isolatoren, isolierte Gate-Treiber oder isolierte DC/DC Wandler. Diese Produkte werden in folgenden technischen Anwendungsgebieten benötigt:
- Industrielle Automatisierung und Steuerung: Einsatz in Sensoren, Steuergeräten und Aktoren zur sicheren Kommunikation zwischen unterschiedlichen Potenzialen und Schutz vor Transienten und Störungen.
- Medizintechnik: Gewährleistung der Isolation in Patientenschaltkreisen bei Geräten wie Monitoren, Scannern oder Defibrillatoren, um Sicherheit und Schutz zu gewährleisten.
- Kommunikationssysteme: Verwendung in Ethernet- oder RS-485-Netzwerken für eine störungsfreie Signalübertragung und Schutz vor Spannungsspitzen in Hochfrequenzumgebungen.
- Energie- und Stromversorgungssysteme: Isolation zwischen Steuerung und Leistungselektronik in Anwendungen wie Wechselrichtern, unterbrechungsfreien Stromversorgungen (USV) und Smart-Grid-Technologien.
- Automobilindustrie: Steuerung und Schutz in Hochspannungsanwendungen, z. B. Batteriemanagementsystemen (BMS) oder Motorsteuerungen in Elektrofahrzeugen.
- Test- und Messgeräte: Sicherstellung der elektrischen Isolation bei der Messung von Signalen in Hochspannungsschaltkreisen und Präzisionsmessgeräten.
- Leistungsumrichter und Wechselrichter: Steuerung und Trennung in Solaranlagen, Windkraftanlagen und industriellen Antriebssystemen.
- Motorsteuerungen: Ansteuerung von AC-, DC- oder BLDC-Motoren in Industrieanlagen oder Haushaltsgeräten mit Optimierung der Schaltzeiten und Minimierung von Verlusten.
- Leistungskonverter: Anwendung in Schaltwandlern (SMPS), DC/DC-Wandlern und bidirektionalen Konvertern zur Sicherstellung der galvanischen Trennung zwischen Primär- und Sekundärseite.
- Energieverteilung und Smart-Grid-Systeme: Einsatz in intelligenten Leistungsschaltern und Transformatoren zur sicheren Steuerung und Isolation.
- Ladesysteme für Elektrofahrzeuge: Anwendung in Schnellladegeräten und drahtlosen Ladesystemen zur sicheren Steuerung von Hochspannungskomponenten.
- Photovoltaiksysteme: Nutzung in Wechselrichtern und Datenkommunikationsschnittstellen zur Trennung und sicheren Steuerung der Module.
- Sicherheits- und Schutzmaßnahmen: Isolation und Schutz vor Spannungsüberschlägen sowie die Vermeidung von Fehlerströmen, die auf Steuerkreise übertragen werden könnten.
- Effiziente Schaltsteuerung: Einsatz in Anwendungen, die schnelle Schaltzeiten und geringe Verluste erfordern, insbesondere in Hochfrequenz- und Hochleistungsanwendungen.

Weitere bevorzugte Merkmale der Erfindung werden anhand von Ausführungsbeispielen und den Figuren erläutert. Dabei bedeuten etwaige angegebenen Maße keine über die Ansprüche hinausgehende Beschränkung. Dabei zeigt:
- Figur 1: einen lateralen Querschnitt eines Ausführungsbeispiels eines erfindungsgemäßen Halbleiterbauelements;
- Figur 2: mit den Teilabbildungen a bis g Verfahrensschritte eines Ausführungsbeispiels eines erfindungsgemäßen Herstellungsverfahrens;
- Figur 3: eine Draufsicht eines Ausführungsbeispiels eines erfindungsgemäßen Halbleiterbauelements;

Gleiche oder gleichwirkende Elemente sind mit gleichen Bezugszeichen gekennzeichnet.

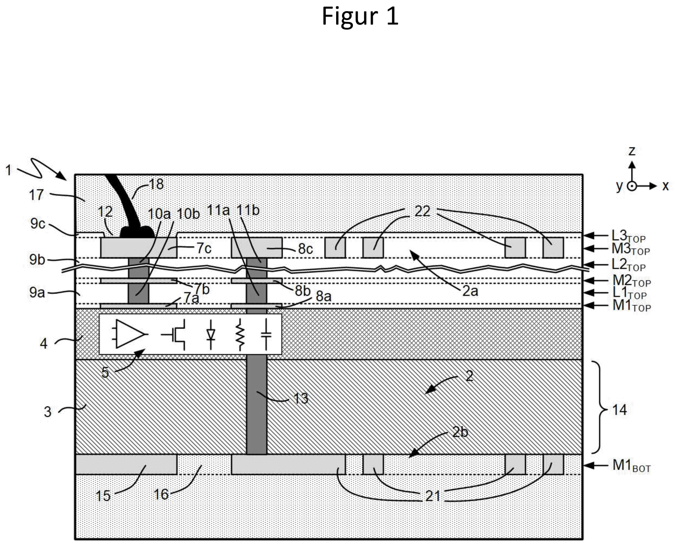

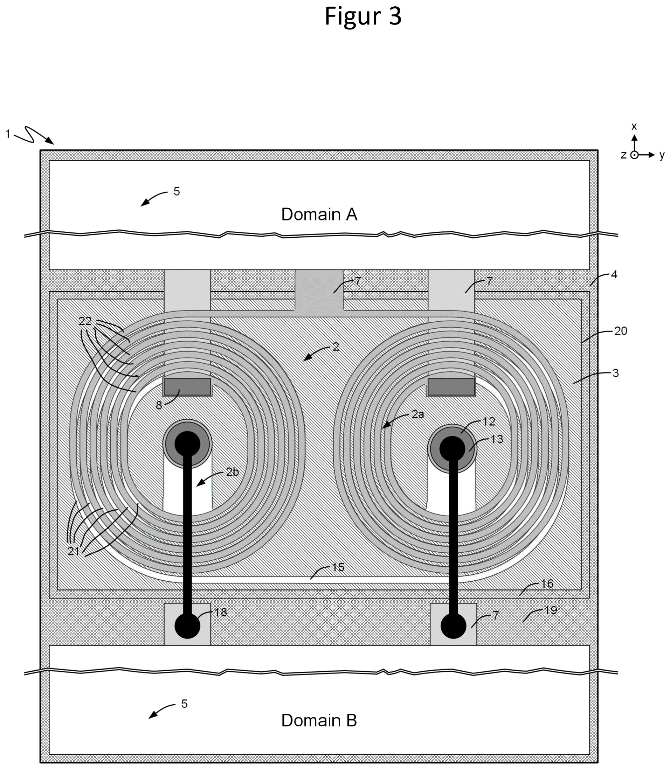

Figur 1 zeigt den lateralen Querschnitt einer Ausführungsform eines erfindungsgemäßen Halbleiterbauelements 1. Das Halbleiterbauelements 1 ist vorliegend mit einem Mikrotransformator 2 mit integrierten Schaltungen einer Schaltungsdomäne A ausgebildet. Eine Ausführungsbeispiel, dass Schaltungen der beiden Schaltungsdomänen A und B enthält ist in Figur 3 gezeigt.

Das isolierende Substrat 3 ist vorliegend als Saphirsubstrat ausgebildet und dient als dielektrische Schicht mit einer Dicke 14 entlang der z-Achse von vorliegend 200 µm. Die Dicke 14 des Substrats wird in Abhängigkeit von der Spannungsklasse gewählt, die erforderlich ist, die gewünschte galvanische Trennung zu gewährleisten.

Das isolierende Substrat 3 wird als Trägersubstrat für den Aufbau der Halbleiterschichtstruktur 4, vorliegend auf Basis der AlGaN/GaN-Technologie, verwendet. Auf dem Substrat 3 wird eine Halbleiterschichtstruktur 4 in Form von Epitaxieschichten für die entsprechende HalbleiterTechnologie gewachsen. Für die AlGaN/GaN-Technologie werden vorliegend eine AlN Nukleationsschicht, GaN Buffer, GaN Kanal, AlGaN Barriere und (p-) GaN-Abdeckung gewachsen. Zusätzlich erfolgt ein Ätzschritt für die Strukturierung des p-GaN Gates bei einer AlGaN/GaN Technologie mit normally-off (engl. Enhancement-mode, e-mode), Ausbildung von Ohm-Kontakten für die Ankontaktierung der Bauelemente und ein Implantationsschritt für die Isolation der aktiven Bauelemente (in diesem Fall High-Electron-Mobility Transistors HEMTs, Schottky-Barrier Diodes SBDs, Lateral Field-Effect Rectifers LFERs, ...) oder der passiven Komponenten (2DEG-Widerstand, p-GaN Gate Kondensator, oder virtuelle Metalllage realisiert durch 2DEG-Schicht). In dieser Ausführungsform als AlGaN/GaN Technologie stehen somit verschiedene aktive Bauelemente, wie normally-on und -off HEMTs, SBDs, LFERs, und passive Komponenten, wie Widerstände, Kondensatoren und Induktivitäten, zur Verfügung mit denen sich die integrierten Schaltungen 5 der Schaltungsdomäne A und/oder B realisieren lassen. Diese Komponenten können grundsätzlich, wie aus dem Stand der Technik bekannt, ausgebildet werden.

Die Schaltungsdomäne A umfasst aktive und passiven Schaltungskomponenten, gekennzeichnet durch das Bezugszeichen 5, in der Halbleiterschichtstruktur 4. Diese aktive und passiven Schaltungskomponenten sind abhängig von der gewünschten Funktionalität des Halbleiterbauelements 1.

Weiter umfasst die Schaltungsdomäne A für die Übertragung von Daten und/oder Energie vorliegend einen Sender oder Oszillator für eine DC/AC Wandlung, während Schaltungsdomäne B den entsprechenden Empfänger oder Gleichrichter für AC/DC-Wandlung beinhaltet. Die integrierten Schaltungen arbeiten mit Spannungen >1 V.

Auf den Epitaxieschichten der Halbleiterschichtstruktur 4 erstrecken sich vorliegend drei Metallisierungsebenen M1_{TOP}, M2_{TOP}, M3_{TOP}, die jeweils entsprechende Metallbereiche 7a, 7b, 7c umfassen. Das vorderseitige Übertragungselement 2a ist vorliegend in der dritten Metallisierungsebene M3_{TOP} ausgebildet.

Auf der der Halbleiterschichtstruktur abgewandten Unterseite des Substrats 3 ist eine rückseitigen Metallisierungsebene M1_{BOT} ausgebildet. Das rückseitige Übertragungselement 2b ist vorliegend in der rückseitigen Metallisierungsebene M1_{BOT} ausgebildet.

Der integrierte Mikrotransformator 2 umfasst somit das vorderseitige Übertragungselement 2a, vorliegend in Form einer oberen Wicklung 21, hier die Primärwicklung, und das rückseitige Übertragungselement 2b, vorliegend in Form einer untere Wicklung 22, hier die Sekundärwicklung, von zwei Spiralspulen eines induktiven Kopplungselements für die galvanische Trennung.

Die Metallisierungsebenen M1_{TOP}, M2_{TOP}, M3_{TOP} können beispielsweise auch für Gate-Kontakte der aktiven Bauelemente, Feldplatten oder Verbindungen zwischen Bauelementen sowie Realisierung passiver Strukturen, wie Kapazitäten und Induktivitäten (nicht dargestellt) genutzt werden. Darüber hinaus können die Metallisierungsebenen M1_{TOP}, M2_{TOP}, M3_{TOP}, weitere Metallbereiche 8a, 8b, 8c für Durchkontaktierungen zu anderen Ebenen des Halbleiterbauelements 1 umfassen.

Der Bereich zwischen vorderseitigem Übertragungselement 2a und dem rückseitigen Übertragungselement 2b kann nicht für integrierte Schaltungen genutzt werden. Dieser Bereich mit den entsprechenden dielektrischen Schichten trägt ebenfalls zur Isolierung zwischen vorderseitigem Übertragungselement 2a und dem rückseitigem Übertragungselement 2b bei.

Jede Metalllage auf der Oberseite M2_{TOP} und M3_{TOP} ist mit der darunter liegenden Metalllage M1_{TOP} und M2_{TOP} über eine Durchkontaktierungsebene L1_{TOP} beziehungsweise L2_{TOP} verbunden, die leitende Durchkontaktierungen (VIAs) 10a und 10b sowie 11a und 11b umfassen. Die Durchkontaktierungen 10a, 10b, 11a, 11b sind vorliegend aus metallischem Material hergestellt. Zwischen jeweils benachbarten Metallisierungsebenen der Metallisierungsebenen M1_{TOP}, M2_{TOP}, M3_{TOP} und der nächsten Metallisierungsebene M1_{TOP}, M2_{TOP}, M3_{TOP} und entlang jedes Metallbereichs, der zu einer gleichen Metallisierungsebene M1_{TOP}, M2 _{TOP}, M3_{TOP} gehört sind dielektrische Schichten 9a-9c, z. B. aus Siliziumnitrid oder Siliziumoxid, vorgesehen.

Zu elektrischen Verbindung mit anderen Schaltungsteilen oder der Außenwelt des Halbleiterbauelements 1 sind ein oder mehrere elektrische Kontaktbereichen 7c aus metallischem Material auf der gleichen Metallisierungsebene M3_{TOP} wie die Primärwicklung 2a vorgesehen. Über diese elektrische Kontaktbereichen 7c können die Wicklungen des vorderseitigen Übertragungselements 22 oder aber auch andere Schaltungsteile kontaktiert werden. Zur Ankontaktierung ist ein Bondbereich 12 mit Bonddraht 18 vorgehsehen. Der Bonddraht 18 und der Bondbereich 12 besteht aus leitfähigem metallischem Material, vorliegend Gold oder Kupfer.

Nur der Bondbereich 12 wird freigelegt zur Ankontaktierung. Alle anderen Strukturen sind durch eine Siliziumnitrid- oder Siliziumoxid-Schicht 9c bedeckt und elektrisch isoliert sowie geschützt. Die oberste dielektrische Schicht 9c dient gleichzeitig für die Passivierung der Außenwelt und der Freistellung der Bondbereiche 12.

Der in Figur 1 dargestellt Querschnitt zeigt eine Technologie mit Planarisierungsverfahren. Das Halbleiterbauelement 1 kann grundsätzlich jedoch auch ohne Planarisierungsverfahren hergestellt werden, wodurch eine Topographie entsteht.

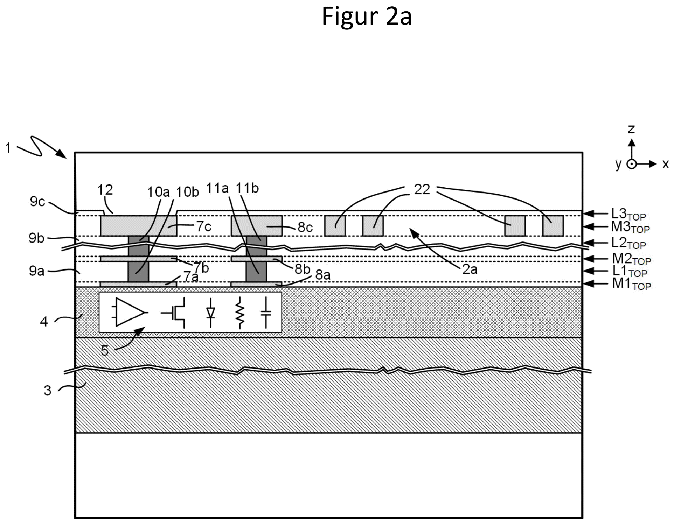

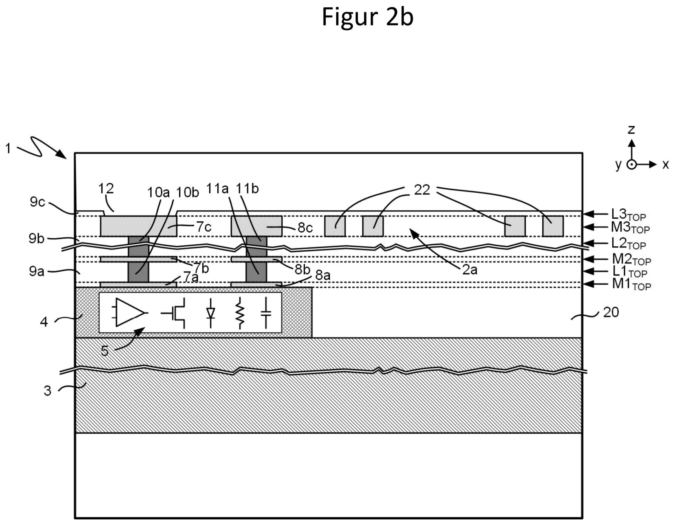

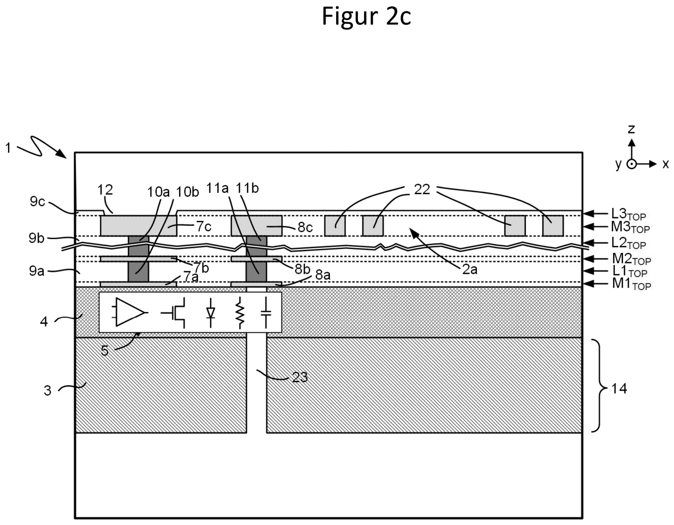

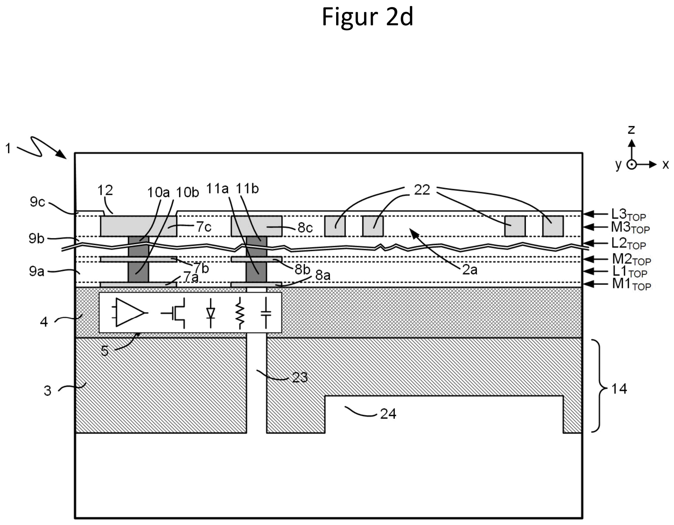

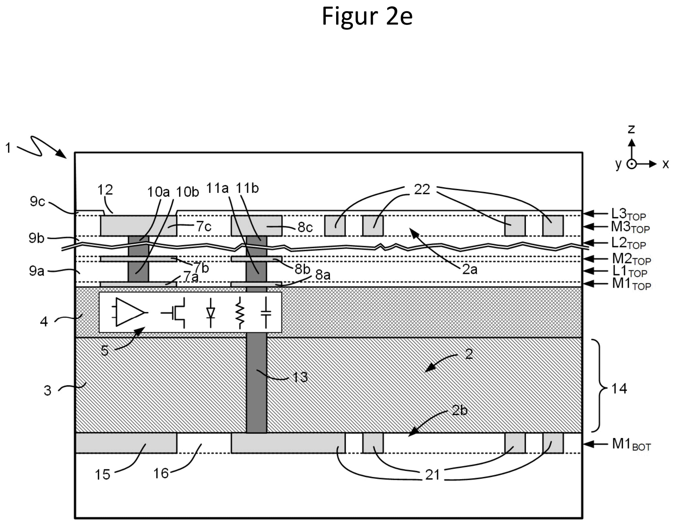

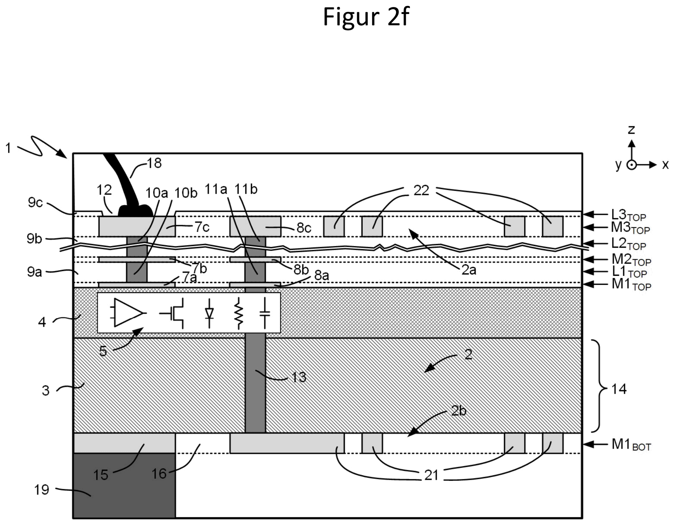

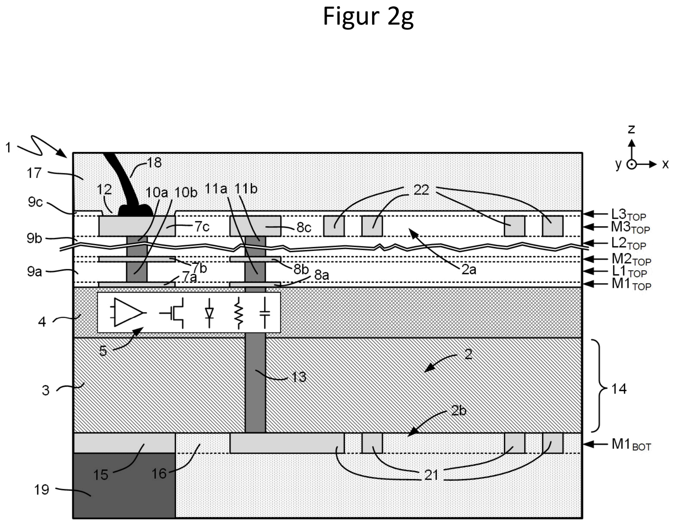

Figur 2 mit den Teilabbildungen a bis g zeigt im Querschnitt die Verfahrensschritte eines Ausführungsbeispiels eines erfindungsgemäßen Herstellungsverfahrens.

Figur 2a zeigt den Querschnitt des Halbleiterbauelements 1 nach der Frontseitenprozessierung. Auf dem Substrat 3 ist die Halbleiterschichtstruktur 4 in Form von Epitaxieschichten aufgebracht. Die Halbleiterschichtstruktur 4 umfasst mehrere elektrische aktive und passive Schaltungskomponenten 5, die je nach geplanten Einsatzzweck des Halbleiterbauelements spezifische Funktionen haben. Unabhängig von den Funktionen der elektronischen Schaltungen 5 sind deren Anschlüsse über die Metallbereiche 7a-7c und die leitenden Durchgänge 10a-10b elektrisch mit der Außenseite des Halbleiterbauelements 1 verbunden.

Bei Figur 2a handelt es sich vorliegend um ein Halbleiterbauelement, das in einer Standard AlGaN/GaN-Technologie ausgebildet ist. Das Substrat 3 ist vorliegend ein isolierendes Saphirsubstrat. Die Separierung oder Isolierung der Schaltungskomponenten 5 kann mittels Implantation oder Ätzung hergestellt werden.

Figur 2b zeigt eine Variation der Frontseitenprozessierung mit einem zusätzlichen Ätzschritt oder der Kombination mit der Isolierung der aktiven Bauelemente. Hierzu werden die Epitaxieschichten der Halbleiterschichtstruktur 4 teilweise weggeätzt 20 in Richtung der negativen z-Achse.

Damit sich die Topographie nicht ändert, kann ein zusätzlicher Planarisierungsschritt durchgeführt werden.

Figur 2c zeigt das Halbleiterbauelement 1 nach dem ersten Schritt der Rückseitenprozessierung. Dabei wird der Substratwafer 3 abgedünnt auf eine Dicke 14 von vorliegend 200 µm. Anschließend werden tiefe Gräben geätzt 23, um die Rückseite mit der Vorderseite über eine Metallisierungsebene anzukontaktieren. Es handelt sich vorliegend um einen mehrstufigen Ätzprozess, indem ein erster selektiver Ätzstopp auf den GaN-Epitaxieschichten der Halbleiterschichtstruktur 4 genutzt wird. Die Kopplung des Isolationselements, vorliegend des Mikrotransformators 2, hängt von dem vertikalen Abstand in z-Richtung ab. Dadurch ergibt sich die Isolationsklasse bzw. maximale Isolationsspannung des Halbleiterbauelements.

Figur 2d zeigt eine Variante des Ätzprozesses aus Figur 2c mit zwei Ätzstufen: Eine Ätzstufe 24 ist im Substrat ausgebildet und die andere Ätzstufe ist bei den Metallisierungsebene M1_{TOP}, M2_{TOP}, M3_{TOP} auf der Frontseite ausgebildet. Durch die Ätzstufen wird die Kopplung zwischen den Wicklungen des vorderseitigen Übertragungselements 22 und den Wicklungen des rückseitigen Übertragungselements 21 erhöht und damit folglich die Effizienz des Mikrotransformators.

Figur 2e zeigt den Querschnitt des Halbleiterbauelements 1 nach der Rückseitenmetallisierung, bei der eine weitere Metallisierungsebene M1_{BOT} ausgebildet wird. Die Metallisierung 15 wird entsprechend mit Gräben 16 strukturiert und kann auch für die Durchkontaktierung 13 zur Vorderseite des Halbleiterbauelements dienen. Gleichzeitig wird in dieser Metallisierungsebene M1_{BOT} die untere Sekundärwicklung 2b des rückseitigen Übertragungselements 21 mit den einzelnen Windungen realisiert.

Nach der Rückseitenprozessierung kann der Wafer mittels Standardvereinzelungstechniken gelasert oder gesägt und anschließend gepickt werden, sodass es sich nur noch um einen einzelnes Halbleiterbauelement 1 handelt, dass das integrierte Isolationselement beinhaltet mit möglichen aktiven integrierten Schaltungsteilen der Domäne A und/oder B. Dieses Halbleiterbauelement 1 kann mit typischen Befestigungstechniken wie Löten, Kleben oder Sintern in ein Gehäuse oder auf einem weiteren Träger befestigt werden, siehe Lötstelle 19 in Figur 2f. Alternativ kann das Halbleiterbauelement 1 auch in eine Leiterplatte eingebettet werden.

Auf der Vorderseite werden Drahtbond-Verbindungen 18 ausgebildet, um das Halbleiterbauelement mit der Außenwelt verbinden zu können, wie in Figur 2f dargestellt. Dies erfolgt beispielsweise über Pins im Falle eines Lead Frames.

In einem nächsten Schritt wird das Halbleiterbauelement 1 mit einer Verkapselung versehen, wie in Figur 2g gezeigt. Dazu wird ein Lack oder eine Harzschicht 17 aufgebracht, vorliegend ein Epoxidharz, die das Halbleiterbauelement 1 sowohl auf der Vorderseite als auch auf der Rückseite bedeckt und einen Teil der Verpackung (nicht vollständig dargestellt) des Halbleiterbauelements 1 bildet. Die Harzschicht 17 dringt in die Gräben 16 und kann die obere Wicklung des vorderseitigen Übertragungselements 22 und die untere Wicklung des rückseitigen Übertragungselements 21 weiter isolieren.

Figur 3 zeigt eines Ausführungsbeispiels eines erfindungsgemäßen Halbleiterbauelements 1 nach der Vereinzelung.

Das Halbleiterbauelement 1 ist mit induktivem Isolationselement in Form von vorderseitigem Übertragungselement 22 und rückseitigem Übertragungselement 21 ausgebildet. Vorderseitiges Übertragungselement 22 und rückseitiges Übertragungselement 21 sind als übereinanderliegende Spulen ausgebildet, die jeweils zwei miteinander verbundene Wicklungen in Form von Spiralspulen aufweisen.

Das Halbleiterbauelement 1 weist zwei integrierte Schaltungsdomänen A und B auf.

Sowohl die Schaltungsdomäne A als auch die Schaltungsdomäne B umfassen aktive und passiven Schaltungskomponenten 5 in den Epitaxieschichten der Halbleiterschichtstruktur 4 des Halbleiterbauelements 1.

Die Schaltungsdomäne A umfasst vorliegend einen Sender oder Oszillator für eine DC/AC Wandlung (nicht dargestellt), während Schaltungsdomäne B den entsprechenden Empfänger oder Gleichrichter für AC/DC-Wandlung (nicht dargestellt) beinhaltet. Die integrierten Schaltungen arbeiten mit Spannungen >1 V.

Der Sender oder Oszillator ist verbunden mit der Primärwicklung 2a des vorderseitigen Übertragungselements 22, während Empfänger oder Gleichrichter mit der Sekundärwicklung 2b des rückseitigem Übertragungselements 21 verbunden ist.

Das vorderseitige Übertragungselement 22 wird über die Kontaktbereiche 7 kontaktiert. Das rückseitige Übertragungselement 21 wird ebenfalls über die Vorderseite des Halbleiterbauelements mittels Durchkontaktierungen 13 kontaktiert.

### Bezugszeichenliste

- 1: Halbleiterbauelement
- 2: Mikrotransformator
- 2a: Primärwicklung
- 2b: Sekundärwicklung
- 3: Substrat
- 4: Halbleiterschichtstruktur
- 5: aktive und passive Schaltungskomponenten
- 7a, 7b, 7c: Metallbereiche/Kontaktbereiche
- 8a, 8b, 8c: Metallbereiche
- 9a, 9b, 9c: dielektrische Schicht
- 10a, 10b-: Durchkontaktierung
- 11a, 11b: Durchkontaktierung
- 12: Bondbereich
- 13: Durchkontaktierung
- 14: Dicke
- 15: Metallisierung
- 16: Struktur/Gräben
- 17: Lack-/Harzschicht
- 18: Bonddraht
- 19: Lötstelle
- 21: rückseitiges Übertragungselement
- 22: vorderseitiges Übertragungselement
- 23: Gräben
- 24: Substrat
- L1_{TOP}, L2_{TOP}: Durchkontaktierungsebene
- M1, M2, M3: Metallisierungsebene
- M1_{TOP}, M2_{TOP}, M3_{TOP}: Metallisierungsebene auf der Oberseite
- M1_{BOT}: Metallisierungsebene auf der Unterseite

## Patentansprüche

1. Verfahren zur Herstellung eines Halbleiterbauelements mit Daten- und/oder Energieübertragung zwischen zwei galvanisch voneinander getrennten Schaltungsdomänen umfassend die folgenden Verfahrensschritte:
A Bereitstellen eines isolierenden Substrats mit einer Oberseite und einer Unterseite;
B Ausbilden einer Halbleiterschichtstruktur durch Aufwachsen und/oder Abscheiden von Epitaxieschichten auf der Oberseite des Substrats, wobei Schaltungen aus aktiven und/oder passiven Schaltungskomponenten zumindest einer der zwei Schaltungsdomänen ausgebildet werden;
C Aufbringen einer Vorderseitenmetallisierung in zumindest einer vorderseitigen Metallisierungsebene mittelbar oder unmittelbar auf der dem Substrat abgewandten Vorderseite der Halbleiterschichtstruktur, wobei die Vorderseitenmetallisierung ein vorderseitiges Übertragungselement für die galvanische Trennung umfasst;
D Aufbringen einer Rückseitenmetallisierung in zumindest einer rückseitigen Metallisierungsebene mittelbar oder unmittelbar auf der der Halbleiterschichtstruktur abgewandten Unterseite des Substrats, wobei die rückseitige Metallisierungsebene ein rückseitiges Übertragungselement für die galvanische Trennung umfasst;
E Ausbilden einer elektrisch leitenden Verbindung zwischen zumindest einer Schaltungsdomäne aus Verfahrensschritt B und dem vorderseitigen oder dem rückseitigen Übertragungselement.

2. Verfahren nach Anspruch 1,
**dadurch gekennzeichnet, dass** in Verfahrensschritt B in der Halbleiterschichtstruktur beide galvanisch voneinander getrennten Schaltungsdomänen ausgebildet werden in Form einer ersten und einer zweiten Schaltungsdomäne, insbesondere dass in einem weiteren Verfahrensschritt eine elektrisch leitende Verbindung zwischen der ersten Schaltungsdomäne und dem vorderseitigen Übertragungselement und der zweiten Schaltungsdomäne und dem rückseitigen Übertragungselement ausgebildet wird oder dass in dem weiteren Verfahrensschritt eine elektrisch leitende Verbindung zwischen der ersten Schaltungsdomäne und dem rückseitigen Übertragungselement und der zweiten Schaltungsdomäne und dem vorderseitigen Übertragungselement ausgebildet wird.

3. Verfahren nach einem der vorgenannten Ansprüche,
**dadurch gekennzeichnet, dass** das Halbleiterbauelement als monolithisch integriertes Halbleiterbauelement ausgebildet wird.

4. Verfahren nach einem der vorgenannten Ansprüche,
**dadurch gekennzeichnet, dass** die Übertragung von Daten und/oder Energie zwischen dem vorderseitigen und dem rückseitigen Übertragungselement induktiv, kapazitiv und/oder mittels einer RF-Antennenanordnung durch elektromagnetische Wellen erfolgt.

5. Verfahren nach einem der vorgenannten Ansprüche,
**dadurch gekennzeichnet, dass** die Halbleiterschichtstruktur auf der Basis von III-V-Verbindungshalbleitern, insbesondere im AlGaN/GaN-Materialsystem, oder auf der Basis von Silizium ausgebildet wird.

6. Verfahren nach einem der vorgenannten Ansprüche,
**dadurch gekennzeichnet, dass** die Dicke des Substrats in Abhängigkeit von der Isolationsspannung des Halbleiterbauelements gewählt wird, die für die galvanische Trennung erforderlich ist.

7. Verfahren nach einem der vorgenannten Ansprüche,
**dadurch gekennzeichnet, dass** in einem Verfahrensschritt vor dem Verfahrensschritt E zumindest in dem Substrat in einem Bereich zwischen dem vorderseitigen Übertragungselement und dem rückseitigen Übertragungselement mittels Ätzverfahren eine Ätzstufe ausgebildet wird und/oder dass in einem Bereich zwischen dem vorderseitigen Übertragungselement und dem rückseitigen Übertragungselement in einem zusätzlichen Verfahrensschritt die Halbleiterschichtstruktur aus Verfahrensschritt B mittels Ätzverfahren entfernt wird.

8. Halbleiterbauelement mit Mittel zur Daten- und/oder Energieübertragung zwischen zwei galvanisch voneinander getrennten Schaltungsdomänen,
mit einem isolierenden Substrat,
einer Halbleiterschichtstruktur, welche Schaltungen aus aktiven und/oder passiven Schaltungskomponenten für zumindest eine erste Schaltungsdomäne der zwei galvanisch voneinander getrennten Schaltungsdomänen umfasst,
und zumindest einer vorderseitigen Metallisierungsebene und zumindest einer rückseitigen Metallisierungsebene,
wobei die Halbleiterschichtstruktur auf einer Oberseite des Substrats angeordnet ist und die vorderseitige Metallisierungsebene mittelbar oder unmittelbar auf der dem Substrat abgewandten Vorderseite der Halbleiterschichtstruktur angeordnet ist und ein vorderseitiges Übertragungselement für die galvanische Trennung aufweist und
wobei die rückseitige Metallisierungsebene mittelbar oder unmittelbar an einer der Halbleiterschichtstruktur abgewandten Unterseite des Substrats angeordnet ist und ein rückseitiges Übertragungselement für die galvanische Trennung aufweist,
wobei das vorderseitige und das rückseitige Übertragungselement zusammenwirkend ausgebildet und angeordnet sind, um Daten und/oder Energie kontaktlos durch magnetische Kopplung, elektrische Kopplung oder mittels elektromagnetischer Wellen zwischen dem vorderseitigen Übertragungselement und dem rückseitigen Übertragungselement zu übertragen und die erste Schaltungsdomäne mit dem vorderseitigen Übertragungselement oder dem rückseitigen Übertragungselement elektrisch leitend verbunden ist.

9. Halbleiterbauelement nach Anspruch 8,
**dadurch gekennzeichnet, dass** das Halbleiterbauelement als monolithisch integriertes Halbleiterbauelement ausgebildet ist.

10. Halbleiterbauelement nach Anspruch 8 oder 9, **dadurch gekennzeichnet, dass** das Substrat eine Dicke aufweist, die in Abhängigkeit von der Isolationsspannung des Halbleiterbauelements für die galvanische Trennung erforderlich ist.

11. Halbleiterbauelement nach einem der Ansprüche 8 bis 10,
**dadurch gekennzeichnet, dass** die Halbleiterschichtstruktur die zweite Schaltungsdomäne der zwei galvanisch voneinander getrennten Schaltungsdomänen umfasst und die erste Schaltungsdomäne mit dem vorderseitigen Übertragungselement und die zweite Schaltungsdomäne mit dem rückseitigen Übertragungselement elektrisch leitend verbunden ist oder dass die erste Schaltungsdomäne mit dem rückseitigen Übertragungselement und die zweite Schaltungsdomäne mit dem vorderseitigen Übertragungselement elektrisch leitend verbunden ist.

12. Halbleiterbauelement nach einem der Ansprüche 8 bis 11,
**dadurch gekennzeichnet, dass** das isolierende Substrat zwischen erstem und zweitem Übertragungselement angeordnet ist.

13. Halbleiterbauelement nach einem der Ansprüche 8 bis 12,
**dadurch gekennzeichnet, dass** das isolierende Substrat aus Saphir, aus semi-isolierendem Siliziumkarbid oder als Silizium-auf-Isolator-Substrat, bevorzugt als Silizium-auf-Saphir-Substrat ausgebildet ist.

14. Halbleiterbauelement nach einem der Ansprüche 8 bis 13,
**dadurch gekennzeichnet, dass** das vorderseitige und das rückseitige Übertragungselement für die Übertragung von Daten und/oder Energie als Spulenpaar, als Kondensator oder als RF-Antennenanordnung ausgebildet ist vorzugsweise, dass das vorderseitige und das rückseitige Übertragungselement als Spulen ausgebildet sind, insbesondere als Spiralspulen, und die Anzahl der Windungen der Spulen zwischen 1 und 30, bevorzugt 3 bis 10 beträgt.

15. Halbleiterbauelement nach einem der Ansprüche 8 bis 14,
**dadurch gekennzeichnet, dass** in der vorderseitigen Metallisierungsebene zumindest ein erster elektrischer Kontaktbereich aus metallischem Material zur Kontaktierung der ersten Schaltungsdomäne und/oder der zweiten Schaltungsdomäne und ein zweiter elektrischer Kontaktbereich aus metallischem Material zur Kontaktierung des rückseitigen Übertragungselements ausgebildet ist.

16. Halbleiterbauelement nach einem der Ansprüche 8 bis 15,
**dadurch gekennzeichnet, dass** die vorderseitige Metallisierungsebene und/oder die rückseitige Metallisierungsebene mehrschichtig ausgebildet sind, bevorzugt dass zwischen Metalllagen der vorderseitigen Metallisierungsebene Durchkontaktierungsebenen vorgesehen sind, die leitende Durchkontaktierungen umfassen, insbesondere bevorzugt dass in der vorderseitigen Metallisierungsebene zumindest eine Durchkontaktierungsebene vorgesehen ist, die zumindest eine leitende Durchkontaktierung durch das Substrat zur rückseitigen Metallisierungsebene aufweist.

17. Halbleiterbauelement nach einem der Ansprüche 8 bis 16,
**dadurch gekennzeichnet, dass** die Halbleiterschichtstruktur auf der Basis von III-V-Verbindungshalbleitern, insbesondere im AlGaN/GaN-Materialsystem, oder auf der Basis von Silizium ausgebildet ist.
